Europäisches Patentamt

European Patent Office

Office européen des brevets

(19)

(11) Publication number: **0 056 571**
**B1**

(12) **EUROPEAN PATENT SPECIFICATION**

(45) Date of publication of patent specification: **02.04.86**

(51) Int. Cl.⁴: **H 01 L 29/08, H 01 L 29/10**

(21) Application number: **82100033.8**

(22) Date of filing: **05.01.82**

(54) **Multi-emitter type npn transistor.**

(30) Priority: **16.01.81 JP 4653/81**

(43) Date of publication of application:
**28.07.82 Bulletin 82/30**

(45) Publication of the grant of the patent:
**02.04.86 Bulletin 86/14**

(84) Designated Contracting States:
**DE FR GB NL**

(56) References cited:
**US-A-3 408 542**

**IBM TECHINCAL DISCLOSURE BULLETIN, vol. 23, no. 7A, December 1980, pages 2739-2740, New York (US); P.T. PATEL: "High density T2L logic circuit"**

**ELECTRONICS, vol. 36, no. 37, 13th September 1963, pages 25-59, New York (USA), P.M. THOMPSON: "Logic principles for multi-emitter transistors"**

**IBM TECHNICAL DISCLOSURE BULLETIN, vol. 14, no. 4, September 1971, page 1104, New York (USA), G. ZEIDENBERGS: "Multiemitter schottky barrier transistor with negligible emitter-to-emitter gain"**

(73) Proprietor: **Kabushiki Kaisha Toshiba
72, Horikawa-cho Saiwai-ku
Kawasaki-shi Kanagawa-ken 210 (JP)**

(72) Inventor: **Nakai, Masanori
276-8, Kamigou
Ebina-shi Kanagawa-ken (JP)**

(74) Representative: **Henkel, Feiler, Hänzel & Partner
Möhlstrasse 37
D-8000 München 80 (DE)**

Courier Press, Leamington Spa, England.

## Description

The present invention relates to a multi-emitter type npn transistor.

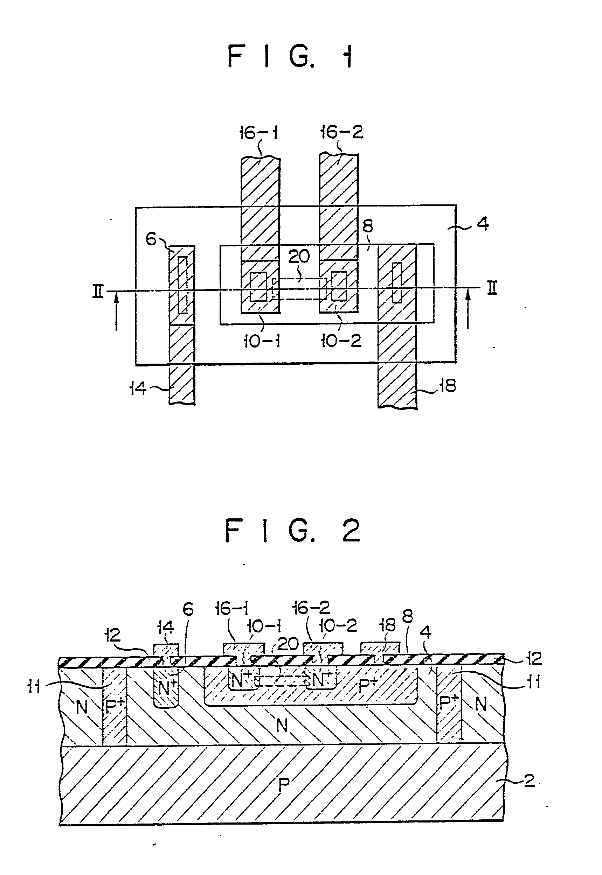

A multi-emitter type npn transistor generally has a structure as shown in Figs. 1 and 2. However, with the structure as shown in Figs. 1 and 2, there is a problem of the formation of a parasitic lateral npn transistor at a region indicated by the broken line, that is, between the two adjacent emitter regions. Describing this in further detail, a conventional npn transistor, as shown in Figs. 1 and 2, comprises a p-type substrate 2, an n-type epytaxial layer 4 formed on the substrate 2, an $n^+$-type region 6 for collector contact formed in the epytaxial layer 4 by the diffusion of an n-type impurity, a $p^+$-type base region 8 formed in the epytaxial layer 4 by the diffusion of a p-type impurity, emitter regions 10-1 and 10-2 formed in the base region 8 by the diffusion of an $n^+$-type impurity, a $p^+$-type isolation region 11, an insulation film 12 having contact holes of predetermined pattern formed on the major surface of the semiconductor body of this construction, and electrodes 14, 16-1, 16-2 and 18 which are in contact with the regions 6, 10-1, 10-2 and 8 through contact holes formed in the insulation film 12. The isolation region 11 and insulation film 12 are omitted in Fig. 1 for simplification. Since the two emitter regions 10-1 and 10-2 are arranged relatively close to each other, the electrons injected to the base region 8 from one emitter region 10-1, for example, reach the other emitter region 10-2, forming a parasitic lateral npn transistor 20 having the emitter region 10-1 as an emitter, the base region 8 as a base, and the emitter region 10-2 as a collector. This parasitic lateral npn transistor affects the original function of the logic circuit formed on the epytaxial layer 4, resulting in erroneous operation of the logic circuit. Document IBM Technical Disclosure Bulletin, Volume 23, No. 7A, December 1980, pages 2739—2740, P. T. PATEL "High density $T^2L$ logic circuit", discloses a multi-emitter type npn transistor which comprises a collector region of n conductivity type, a base region of p conductivity type, a plurality of emitter regions of n conductivity type formed in said base region, and a collector contact. In this transistor, a plurality of emitter electrodes are in contact with the plurality of emitter regions. Base electrodes made of polycrystalline silicon are provided in contact with the base regions which lie between two adjacent emitter regions, and the base region is connected to an external positive power supply.

A similar multi-emitter type npn transistor structure is disclosed in Electronics, Volume 36, No. 37, 13th September 1963, pages 25—29, P. M. THOMPSON "Logic principles for multi-emitter transistors".

It is an object of the present invention to provide a multi-emitter type npn transistor of a construction so that the formation of an undesirable parasitic lateral npn transistor may be prevented.

In order to achieve this object, there is provided according to the present invention, a multi-emitter type npn transistor comprising:

a collector region of n conductivity type, a base region of p conductivity type, a plurality of emitter regions of n conductivity type formed in said base region, a collector electrode which is in contact with said collector region, a plurality of emitter electrodes which are in contact with the plurality of emitter regions, respectively, and a base electrode means which is in contact with that portion of said base region which lies between any two adjacent ones of said plurality of emitter regions, said multi-emitter type npn transistor being characterized in that the base electrode means comprise at least one base electrode which is for connection with an external power supply at positive potential, and at least one intermediate base electrode only provided for attracting the electrons and which is not directly connected to the external power supply.

This invention can be more fully understood from the following detailed description when taken in conjunction with the accompanying drawings, in which:

Fig. 1 is a plan view showing the configuration of a conventional multi-emitter type npn transistor;

Fig. 2 is a sectional view of the transistor viewed along the line II—II of Fig. 1 indicated by the arrows;

Fig. 3 is a graph showing the characteristic curves of the current amplification $\beta$ as a function of the base current IB of the conventional multi-emitter npn type transistor shown in Figs. 1 and 2 and the multi-emitter npn type transistor of the present invention;

Fig. 4 is a plan view of a multi-emitter type npn transistor according to an embodiment of the present invention;

Fig. 5 is a sectional view of the transistor viewed along the line VI—VI of fig. 4 indicated by the arrows; and

Fig. 6 is a plan view of a multi-emitter type npn transistor according to another embodiment of the present invention.

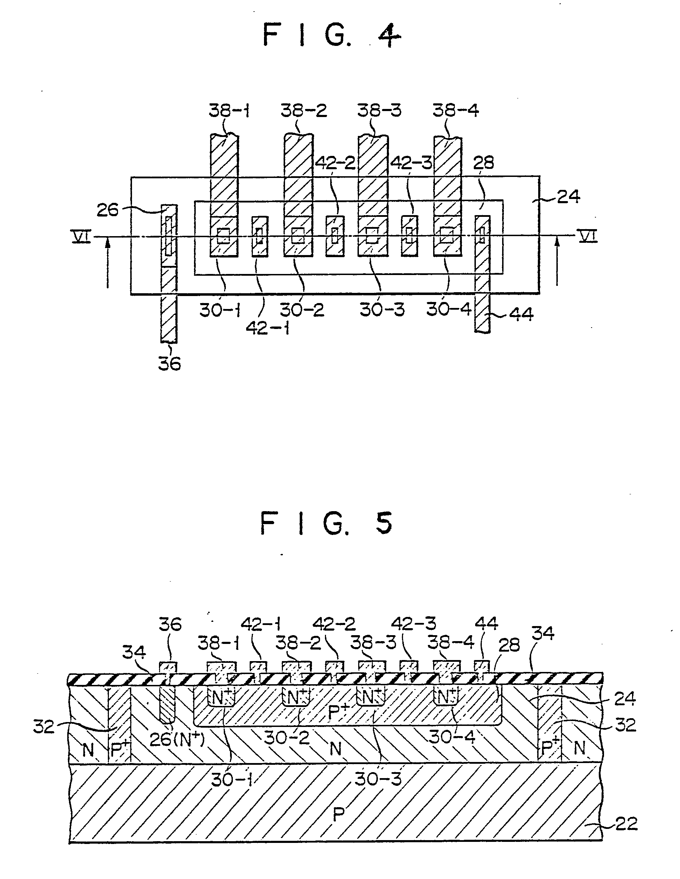

Figs. 4 and 5 show a multi-emitter type npn transistor according to an embodiment of the present invention. According to this embodiment, an n-type epitaxial layer 24 is formed on a silicon substrate 22 of p conductivity type. In the epitaxial layer 24 are formed an $n^+$-type collector contact region 26, and a $p^+$-type base region 28. With the $p^+$-type base region 28 are formed emitter regions 30-1 to 30-4. A $p^+$-type region 32 is an isolation region. The epitaxial layer 24 defines the collector region. An insulation film 34 of, for example, $SiO_2$ (silicon dioxide) having contact holes of predetermined pattern is formed on the major surface of the semiconductor body of this configuration. Electrodes 36 and 38-1 to 38-4 of aluminum, for example, are formed in the $n^+$-type collector contact region 26, and the $n^+$-type emitter regions 30-1 to 30-4 through the contact holes formed in the insulation film 34. The isolation region 32 and insulation film 34 are omitted in Fig. 4 for the sake of simplification.

Base region contact holes are formed at the positions of the insulation film which correspond to the emitter regions 30-1, 30-2, 30-3 and 30-4. A base electrode 42-1 is in contact with the base region portion between the emitter regions 30-1 and 30-2, base electrode 42-2 is in contact with the base region portion between the emitter regions 30-2 and 30-3. A base electrode 42-3 is in contact with the base region portion between the emitter regions 30-3 and 30-4. A base electrode 44 is in contact with the base region portion which is not sandwiched between the emitter regions (the right edge of the base region 28 shown in Figs. 4 and 5) through the contact hole.

The base electrode 44 is for connection with an external power supply (not shown) at positive potential and is connected with such an external power supply during operation. On the other hand, the base electrodes 42-1, 42-2 and 42-3 are the electrodes for attracting the electrons. Although these electrodes 42-1, 42-2 and 42-3 are not directly connected to the external power supply, they are electrically connected to the external power supply through the base region 28 since the base electrode 44 is connected to the external power supply to be kept at a positive potential. Therefore, these electrodes 42-1, 42-2 and 42-3 are kept at substantially the same positive potential (potential of the external power supply) as the base electrode 44.

Therefore, the electrons injected to the base region 28 from the emitter regions 30-1, 30-2 and 30-3, and 30-4 are attracted to the base electrodes 42-1, 42-2 and 42-3 and the interfaces between these base electrodes and the base region 28 so that these electrons may be recombined with the holes at these interfaces. In this manner, the electrons injected into the base region 28 are prevented from reaching the other emitter regions, so that the formation of lateral npn transistors between the adjacent emitter regions is prevented.

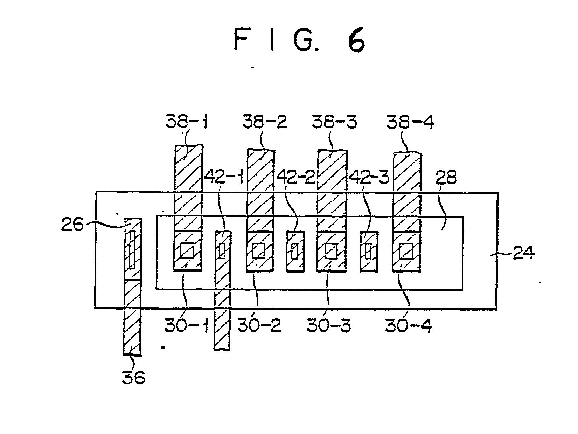

In the embodiment shown in Figs. 4 and 5, the base electrodes 42-1, 42-2 and 42-3 are electrically connected to the base electrode 44 for connection with the external power supply through the base region 28, so that the base electrodes are kept at substantially the same potential as the base electrode 44. However, the present invention is not limited to this configuration. For example, at least one of the base electrodes 42-1, 42-2 and 42-3 (the base electrode 42-1 as shown in Fig. 6) may be extended and may be connected to the external power supply. In this case, as in the case of the embodiment shown in Figs. 4 and 5, the base electrodes 42-2 and 42-3 are electrically connected to the base electrode 42-1 through the base region 28, so that the base electrodes 42-2 and 42-3 are kept at substantially the same potential as the base electrode 42-1 (potential of the external power supply). In this case, the base electrode 44 for connection with the external power supply as in Figs. 4 and 5 need not be formed.

In any of the embodiments decribed above, it is preferable to space the base electrodes sufficiently apart in order to enhance the effect of attracting the electrons.

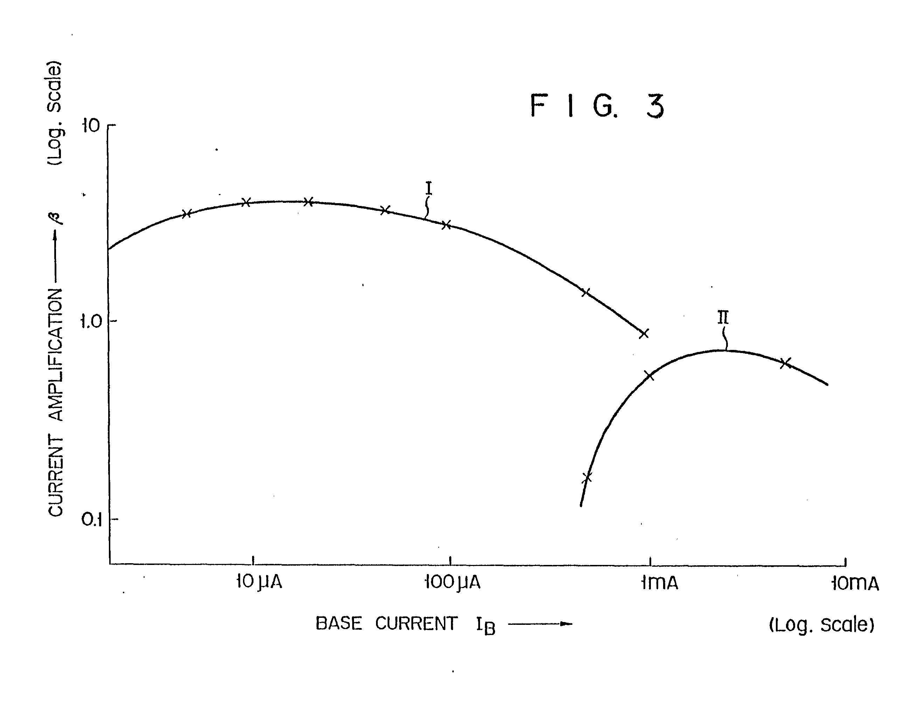

In summary, according to the present invention, in a multi-emitter type npn transistor, at least one base electrode which is not directly connected to the external power supply is arranged at the base region portion between two adjacent emitter regions. During operation, a positive voltage is applied to at least one base electrode, which is for connexion with an external power supply so that the electrons injected into the base region from the emitter regions may be attracted to the interface between the base electrode and the base region to be recombined with the holes at this interface. Therefore, injected electrons are prevented from reaching the other emitter region, and the formation of a parasitic lateral npn transistor may be prevented. This is seen from the characteristic curves of the current amplification $\beta$ as a function of the base current $I_B$ for the conventional npn transistor shown in Figs. 1 and 2 and the npn transistor according to the present invention. Referring to Fig. 3, curve I is the characteristic curve for the conventional npn transistor, and curve II is the characteristic curve for the npn transistor of the present invention. The ordinate and abscissa in Fig. 3 are both logarithmic scales. The distance between the emitters on the mask during the manufacture of the conventional npn transistor of the curve I was set to 40 $\mu$m, and the distance between the emitters on the mask during the manufacture of the npn transistor of the present invention of the curve II was set to 30 $\mu$m. Thus the distance between the emitters in the npn transistor according to the present invention is set smaller than the distance between the emitter regions of the conventional npn transistor. Despite this fact, as may be seen from Fig. 3, the current amplification $\beta$ of the conventional npn transistor (curve I) is 2 to 4 while the current amplification $\beta$ of the npn transistor (curve II) of the present invention is about 0.1 in the low current range and is 0.5 to 0.7 even in the high current range. In this way, it is seen that the npn transistor of the present invention achieves better results than the npn transistor shown in Figs. 1 and 2.

**Claim**

A multi-emitter type npn transistor comprising:
a collector region (24) of n conductivity type,
a base region (28) of p conductivity type,
a plurality of emitter regions (30-1, 30-2, 30-3, 30-4) of n conductivity type formed in said base region (28),
a collector electrode (36) which is in contact with said collector region (24),
a plurality of emitter electrodes (38-1, 38-2, 38-3, 38-4) which are in contact with the plurality of emitter regions (30-1, 30-2, 30-3, 30-4), respectively, and

a base electrode means (42-1, 42-2, 42-3) which is in contact with that portion of said base region (28) which lies between any two adjacent ones of said plurality of emitter regions (30-1, 30-2, 30-3, 30-4), characterized in that the base electrode means comprise at least one base electrode which is for connection with an external power supply at positive potential, and at least one intermediate base electrode (42-1, 42-2, 42-3) only provided for attracting the electrons and which is not directly connected to the external power supply.

## Revendication

Transistor NPN du type à émetteurs multiples, comportant: une région de collecteur (24) du type de conductivité N, une région de base (28) du type de conductivité P, plusieurs régions d'émetteurs (30-1, 30-2, 30-3, 30-4) de type de conductivité N, formées dans ladite région de base (28), une électrode de collecteur (36) qui est en contact avec ladite région de collecteur (24), plusieurs électrodes d'émetteurs (38-1, 38-2, 38-3, 38-4) qui sont en contact avec les régions d'émetteurs (30-1, 30-2, 30-3, 30-4) respectivement et une électrode de base (42-1, 42-2, 42-3) qui est en contact avec la partie de ladite région de base (28) se situant entre deux régions voisines parmi lesdites régions d'émetteurs (30-1, 30-2, 30-3, 30-4), caractérisé en ce que ladite électrode de base comporte au moins une électrode de base destinée à être connectée à une source d'alimentation extérieure à un potentiel positif et au moins une électrode de base intermédiaire (42-1, 42-2, 42-3) prévue seulement pour attirer les électrons et qui n'est pas connectée directement à la source d'alimentation extérieure.

## Patentanspruch

Vielfachemitter-npn-Transistor, umfassend eine Kollektorzone (24) des n-Leitfähigkeitstyps, eine Basiszone (28) des p-Leitfähigkeitstyps, mehrere in der Basiszone (28) ausgebildete Emitterzonen (30-1, 30-2, 30-3, 30-4) des n-Leitfähigkeitstyps, eine mit der Kollektorzone (24) in Kontakt stehende Kollektorelektrode (36), mehrere mit den jeweiligen Emitterzonen (30-1, 30-2, 30-3, 30-4) in Kontakt stehende Emitterelektroden (38-1, 38-2, 38-3, 38-4) und eine Basiselektrodeneinrichtung (42-1, 42-2, 42-3), die mit dem Bereich der Basiszone (28) in Kontakt steht, der zwischen je zwei benachbarten der verschiedenen Emitterzonen (30-1, 30-2, 30-3, 30-4) liegt, dadurch gekennziechnet, daß die Basiselektrodeneinrichtung mindestens eine Basiselektrode für die Verbindung mit einer externen Stromversorgung positiven Potentials und mindestens eine Zwischen-Basiselektrode (42-1, 42-2, 42-3), die nur zum Anziehen der Elektronen dient und die nicht unmittelbar mit der externen Stromversorgung verbunden ist, umfaßt.

# F I G. 1

# F I G. 2

1

F I G. 3

CURRENT AMPLIFICATION ——→ β (Log. Scale)

BASE CURRENT I$_B$ ——→ (Log. Scale)

0 056 571

# F I G. 4

38-1    38-2    38-3    38-4

42-2    42-3    28

26        24

VI             VI

30-1    30-2    30-3    30-4    44

42-1

36

# F I G. 5

36    42-1    42-2    42-3    44    34

34   38-1   38-2   38-3   38-4   28

24

N⁺    N⁺    N⁺    N⁺

32       P⁺            30-4       32

26(N⁺)    30-2    N           P⁺    N

32    N   P⁺

30-1       30-3

P            22

# F I G. 6